Europäisches Patentamt

European Patent Office

Office européen des brevets

(19)

(11) **EP 1 304 499 A1**

## (12) EUROPEAN PATENT APPLICATION
published in accordance with Art. 158(3) EPC

(43) Date of publication:
**23.04.2003 Bulletin 2003/17**

(21) Application number: **01949958.1**

(22) Date of filing: **12.07.2001**

(51) Int Cl.⁷: **F16F 15/03**, G05D 19/02

(86) International application number:
**PCT/JP01/06050**

(87) International publication number:
**WO 02/006700 (24.01.2002 Gazette 2002/04)**

(84) Designated Contracting States:
**DE FR GB**

(30) Priority: **13.07.2000 JP 2000212406**

(71) Applicant: **EBARA CORPORATION**
**Ohta-ku, Tokyo 144-8510 (JP)**

(72) Inventors:
• **WATANABE, Katsuhide**
**Fujisawa-shi, Kanagawa 251-0045 (JP)**

• **HAGA, Takahide**
**Fujisawa-shi, Kanagawa 251-0003 (JP)**
• **KANEMITSU, Yoichi**
**Fukuoka-shi, Fukuoka 814-0111 (JP)**

(74) Representative: **Wagner, Karl H., Dipl.-Ing.**
**Wagner & Geyer,**
**Patentanwälte,**
**Gewürzmühlstrasse 5**
**80538 München (DE)**

## (54) VIBRATION ISOLATING DEVICE USING MAGNETIC LEVITATING DEVICE

(57) For stably supporting a vibration isolating table to isolate a vibration-protected apparatus from external vibrations, a vibration isolating apparatus comprises a vibration isolating table 10; magnetic levitation devices 31 - 34 for supporting the vibration isolating table 10 without contact and applying a control force thereto; displacement sensors 41 - 44 for detecting amounts of relative displacement of the vibration isolating table 10 with respect to a foundation to output displacement signals; and acceleration sensors 61 - 63 for outputting acceleration signals upon detection of vibrations of the foundation. A controller 5 comprises a first control loop for feeding the displacement signals back to the magnetic levitation devices 31 - 34 to determine a relative position of the vibration isolating table 10 with respect to the foundation; and a second control loop for compensating the acceleration signals and feeding the compensated acceleration signals forward to the magnetic levitation devices 31 - 34 to suppress vibrations propagating from the foundation to the vibration isolating table 10.

Fig.4

**Description**

TECHNICAL FIELD

The present invention relates to an accurate vibration isolating apparatus for isolating, from external vibrations, a foundation such as an installation floor for such an apparatus as a semiconductor manufacturing apparatus, an electric microscope and the like which may suffer problems of a reduction in yield and accuracy of products when the external vibrations propagate to the facilities. From another point of view, the present invention relates to a positioning apparatus for isolating such facilities from small vibrations for accurate positioning.

BACKGROUND ART

With the trend of increasingly higher accuracy sought for a vibration-protected apparatus such as a semiconductor manufacturing apparatus, an electronic microscope, and the like, the performance of a vibration isolating apparatus has been enhanced for preventing the transmission of vibrations to a vibration isolating table such as a table on which a vibration-protected apparatus is installed. For example, Japanese Laid-open Patent Application No. 9-112628 and U.S. Patent No. 5,793,598 disclose a high precision magnetically levitated vibration isolating apparatus which supports a vibration isolating table on which a high precision device is installed, using an electromagnetic actuator without contact to isolate the vibration isolating table from small vibrations propagated from an installation floor. This magnetically levitated vibration isolating apparatus feeds, back to the electromagnetic actuator through a controller, a relative displacement between the installation floor and the vibration isolating table as well as an acceleration of the vibration isolating table when it moves, thereby stably supporting the vibration isolating table and an apparatus installed thereon without contact as well as isolating vibrations from the installation floor such that the vibrations do not propagate to the installed apparatus.

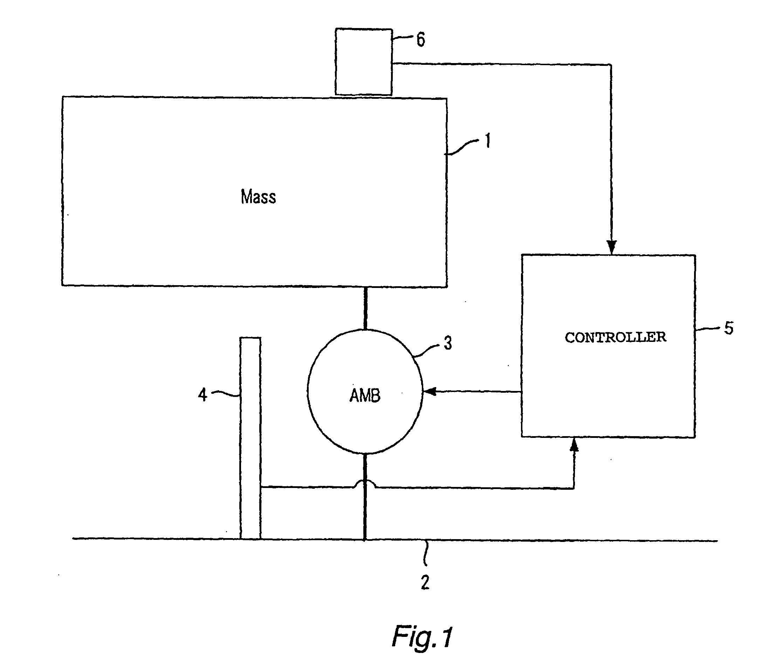

Fig. 1 is a conceptual diagram illustrating a conventional magnetically levitated vibration isolating apparatus when it is represented as a system having one degree of freedom. In Fig. 1, a mass (Mass) 1, which is a table that carries a vibration-protected apparatus such as a high precision device, is stably supported on an installation floor 2, which defines a reference position, through a magnetic levitation device (Active Magnetic Bearing) 3 without contact. A displacement in the relative position of the mass 1 to the installation floor 2 is detected by a displacement sensor 4, and a detected displacement signal is supplied to a controller 5.

An acceleration sensor 6 is also attached to the mass 1 for detecting an acceleration of the mass 1 when it vibrates due to vibrations from the installation floor 2 and vibrations of the mass system itself. An acceleration signal detected by the acceleration sensor 6 is also supplied to the controller 5. Controller 5 uses the displacement signal and acceleration signal supplied thereto in this way to generate a control signal which is in turn applied to the magnetic levitation device 3 to prevent the mass 1 from vibrating due to vibrations of the installation floor, thereby isolating the mass 1 from vibrations of the installation floor 2.

While the conventional magnetically levitated vibration isolating apparatus can demonstrate high vibration isolating capabilities as described above, the isolation isolating apparatus is essentially an instable system. As a result, in order to enhance the stability, an absolute velocity component calculated by integrating an acceleration of the vibration isolating table when it moves is fed back to the magnetic levitation device 3 through the controller 5.

However, the conventional vibration isolating apparatus is disadvantageous in that it can fail to maintain the vibration isolating performance by the following reasons:

1. It is difficult to stabilize the vibration isolating apparatus due to poor frequency characteristics of an highly accurate acceleration sensor when used at a low frequency.
2. When an excessively large disturbance is applied to the vibration isolating table or when the vibration isolating table vibrates due to motions of a device installed on the vibration isolating table, such disturbance and vibrations affect the vibration isolating apparatus and make its control system instable.

The present invention has been proposed to solve the foregoing problems inherent to the'conventional vibration isolating apparatus, and its object is to provide a vibration isolating apparatus which stably operates to isolate a vibration-protected apparatus from external vibrations without fail.

DISCLOSURE OF THE INVENTION

To achieve the above object, the present invention provides a vibration isolating apparatus characterized by comprising:

a vibration isolating table for installing a vibration-protected apparatus thereon;

an electromagnetic actuator for supporting the vibration isolating table without contact and applying a control force thereto;

displacement detecting means for detecting an amount of a relative displacement of the vibration isolating table with respect to a foundation which defines a reference position to output a displacement signal;

first vibration detecting means for outputting a first acceleration signal upon detection of vibrations of the foundation;

a first control loop for applying a predetermined compensation to the displacement signal and feeding the compensated displacement signal back to the electromagnetic actuator to determine a relative position of the vibration isolating table with respect to the reference position; and

a second control loop for compensating the first acceleration signal and feeding the compensated first acceleration signal forward to the electromagnetic actuator to prevent vibrations from propagating from the foundation to the vibration isolating table.

This vibration isolating apparatus may further comprise second vibration detecting means for outputting a second acceleration signal upon detection of the vibrations of the vibration isolating table. Thus, the second control loop operates to prevent the vibrations of the foundation from propagating to the vibration isolating table using the first acceleration signal as an error signal and the second acceleration signal as a reference signal.

Preferably, the first control loop includes a PID compensator and a phase advance/delay compensator, and the second control loop includes an adaptive filter for updating a filter coefficient based on an adaptive algorithm to form a feed-forward signal.

While the electromagnetic actuator operates to apply the control force for supporting the vibration isolating table without contact by exerting a magnetic force to a magnetic material fixed to the vibration isolating table, the vibration isolating table may be supported additionally by a resilient supporting member in order to mitigate the burden on the electromagnetic actuator. Preferably, the vibration isolating table is a table or a stage plate for supporting a vibration-protected object.

In the vibration isolating apparatus of the present invention, a relative displacement of the vibration isolating table with respect to the foundation is detected by the displacement sensor, such that the controller maintains the vibration isolating table at a predetermined position using the displacement signal outputted from the displacement sensor. On the other hand, the acceleration sensor attached on the foundation outputs the acceleration signal upon detection of vibrations of the foundation, such that the controller prevents the vibrations of the foundation from propagating to the vibration isolating table using the acceleration signal.

BRIEF DESCRIPTION OF THE DRAWINGS

Fig. 1 is a diagram for explaining the configuration of a conventional vibration isolating apparatus;

Fig. 2 is a diagram generally illustrating the configuration of a first embodiment of a vibration isolating apparatus according to the present invention in terms of a system having one degree of freedom;

Fig. 3 is a diagram for explaining how control is conducted in the vibration isolating apparatus illustrated in Fig. 2;

Fig. 4 is a diagram illustrating a specific configuration of the first embodiment of the vibration isolating apparatus according to the present invention;

Fig. 5 is a diagram generally illustrating the configuration of a controller in Fig. 4;

Fig. 6 is a diagram generally illustrating the configuration of a second embodiment of a vibration isolating apparatus according to the present invention in terms of a system having one degree of freedom;

Fig. 7 is a diagram for explaining how control is conducted in the vibration isolating apparatus illustrated in Fig. 6;

Fig. 8(a) is a diagram for explaining an LMS algorithm, and Fig. 8(b) is a diagram for explaining a Filtered-X LMS algorithm;

Fig. 9 is a diagram illustrating a specific configuration of the second embodiment of the vibration isolating apparatus according to the present invention;

Fig. 10 is a diagram generally illustrating the configuration of a controller in Fig. 9; and

Fig. 11 is a diagram generally illustrating the configuration of a third embodiment of a vibration isolating apparatus according to the present invention in the form of a system having one degree of freedom.

BEST MODE FOR CARRYING OUT THE INVENTION

In the following, embodiments of a vibration isolating apparatus according to the present invention will be described in detail with reference to the drawings.

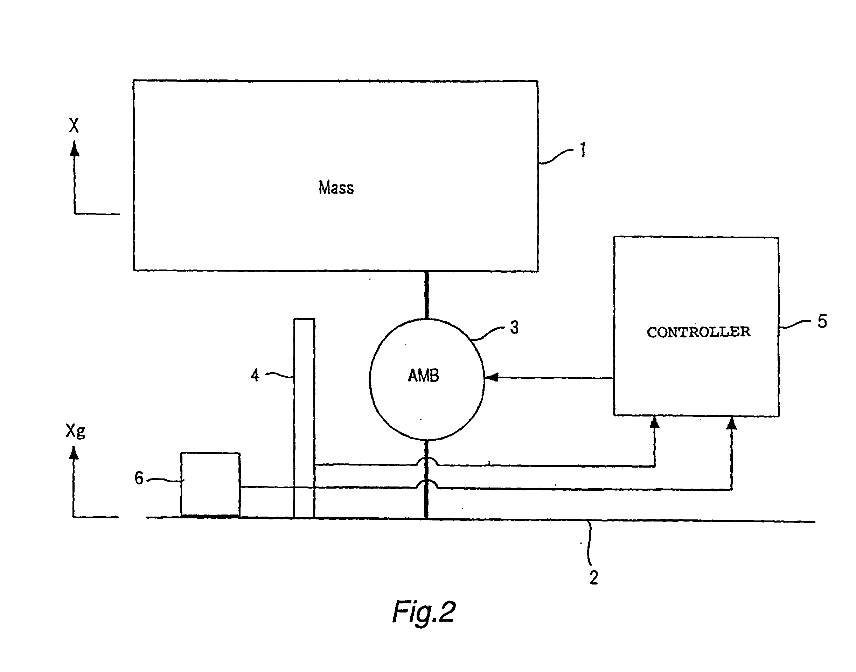

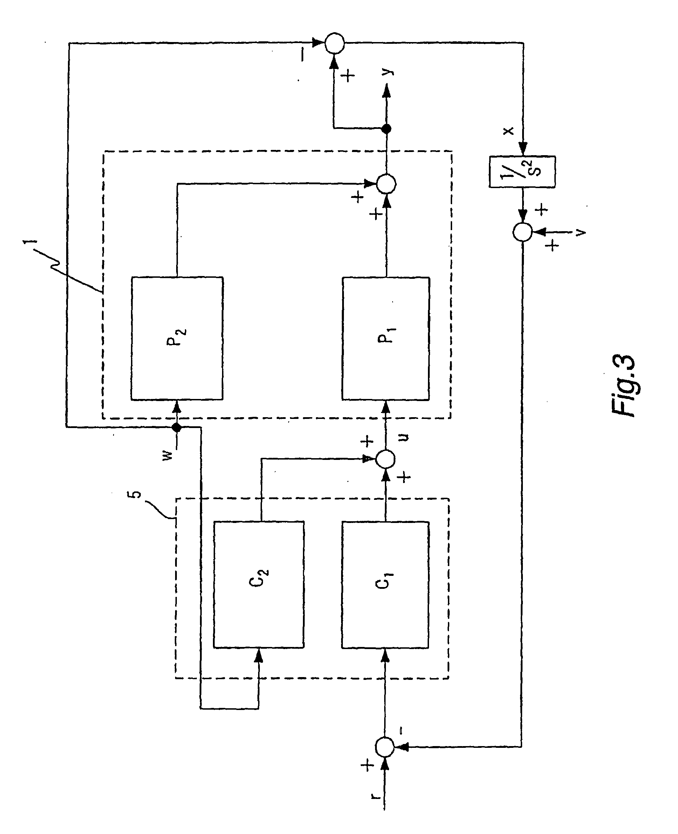

In Figs. 2 to 11, components identical or similar to the those illustrated in Fig. 1 are designated by the same reference numerals. Also, in Figs. 3, 5, 7 and 9, the same reference numerals denote identical or similar signals.

Fig. 2 is a conceptual diagram illustrating a first embodiment of a vibration isolating apparatus according to the present invention when it is represented as a system having one degree of freedom. In Fig. 2, a mass 1 including a table which carries a vibration-protected apparatus such as a semiconductor manufacturing apparatus, an electric microscope or the like is stably supported on an installation floor 2, which defines a reference position, through a magnetic levitation device 3 without contact. A displacement of a relative position of the mass 1 to the installation floor (reference position) 2 in an x-direction is detected by a displacement sensor 4, and a detected displacement signal is supplied to a controller 5. An acceleration sensor 6 is also attached on the installation floor 2 for detecting an acceleration of the installation floor 2 when it vibrates in an xg-direction. The acceleration sensor 6 supplies the controller 5 with an acceleration signal indicative of a detected acceleration.

The controller 5 processes the displacement signal supplied thereto to generate a first control signal which is fed back to the magnetic levitation device 3 for adjusting a supporting force of the magnetic levitation device 3 to maintain the mass 1 at a predetermined position. Simultaneously, the controller 5 uses the acceleration signal from the acceleration sensor 6 to feed a second control signal forward to the magnetic levitation device 3 to prevent vibrations of the installation floor 2 from propagating to the mass 1. In this way, the mass 1 is isolated from the vibrations of the installation floor 2.

The magnetic levitation device 3 comprises an electromagnetic actuator arranged around a magnetic material such as a permanent magnet fixed on the table for installing the vibration-protected apparatus thereon. The controller 5 applies the electromagnetic actuator with the first control signal and second control signal to impose a magnetic force generated thereby to the magnetic material of the mass 1, thus stably supporting the mass 1 out of contact.

Here, the apparatus in Fig. 2 may be re-drawn as represented by a block diagram in Fig. 3 in regard to a control system. Referring now to Fig. 3, consider conditions for preventing the vibrations of the installation floor 2 from propagating to the mass 1. Assume now that a reference position of the mass 1 is represented by r; noise of the displacement sensor 4 by v; a relative displacement of the mass 1 by x; the output of the acceleration sensor 6, i.e., an absolute acceleration indicated by the mass 1 through vibrations by y; and vibrations of the installation floor 2, i.e., disturbance by w. Then, v, x, r and w are input to the controller 5. The controller 5 comprises a first controller $C_1$ for processing v, x, r, and a second controller $C_2$ for processing w, and outputs a control input u. Specifically, the first controller $C_1$ receives a detection output from the displacement sensor 4 which is processed to control the magnetic levitation device 3 and stably levitate the mass 1, while the second controller $C_2$ receives a detection output from the acceleration sensor 6 which is processed to improve a vibration transmission rate of the vibration isolating apparatus using the magnetic levitation device 3. The results of the processing by these controllers are added to generate the control input u.

Further, in Fig. 3, $P_1$ represents a transfer function (dynamic characteristic) from a force u such as the disturbance, a control force and the like to the acceleration of the mass 1, and $P_2$ represents a transfer function (dynamic characteristic) from the acceleration of the installation floor to the acceleration of the mass.

To prevent the vibrations of the installation floor 2 from propagating to the mass 1, a condition is found for minimizing the gain of the transfer function from w to y. First, Equation (1) is established on a path from the input v to the output y:

$$y = -P_1 C_1 v - P_1 C_1 (1/s^2) x \tag{1}$$

Here, since x=y when w=0, a transfer function from the input v to the output y is given from Equation (1) as follows:

$$y/v = (-P_1 C_1 s^2)/(s^2 + P_1 C_1) \tag{2}$$

On the other hand, Equation (3) is established for a path from the input r to the output y:

$$y = -P_1 C_1 (1/s^2) x + P_1 C_1 r \tag{3}$$

Here, since x=y when w=0, a transfer function from the input r to the output y is given from Equation (3) as follows:

$$y/r = +(P_1 C_1 s^2)/(s^2 + P_1 C_1) \qquad (4)$$

Further, Equation (5) is established for a path from the disturbance w to the output y:

$$y = P_2 w - P_1 C_1 (1/s^2) + P_1 C_2 w \qquad (5)$$

Here, since

$$x = y - w \qquad (6)$$

a transfer function from the disturbance w to the output y is given as follows:

$$y/w = (P_2 \cdot s^2 + P_1 C_1)/(s^2 + P_1 C_1) + (P_1 C_2 \cdot s^2)/(s^2 + P_1 C_1) \qquad (7)$$

where $y/r = -y/r$, and y/w is given by:

$$y/w = P_2 \{(1 + (y/v)(1/s_2)\} - (y/v)(1/s^2) +$$

$$P_1 \{1 + (y/v)(1/s_2)\} C_2 \qquad (8)$$

It can therefore be seen that the transfer function y/w can be changed by $C_2$ even when the transfer function y/v is determined. Moreover, $C_2$ does not affect the transfer functions y/v, y/r, so that the transfer function y/w can be independently adjusted in the characteristics by $C_2$, and y/r is determined by y/v. It can therefore be seen that the vibration isolating apparatus illustrated in Fig. 2 is a system having two degrees of freedom.

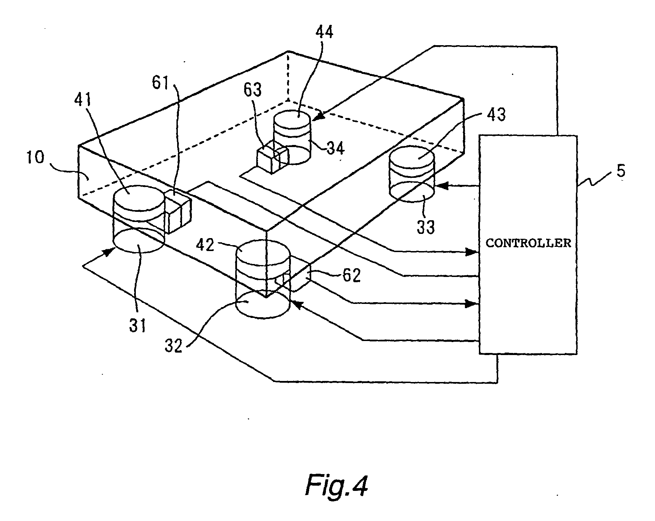

Assuming the foregoing described in connection with Figs. 2 and 3, a specific configuration of the first embodiment of the vibration isolating apparatus according to the present invention is illustrated in Fig. 4. An appropriate number (four in Fig. 4) of magnetic levitation devices 31, 32, 33, 34 are disposed at appropriate positions on the lower surface of a vibration isolating table 10 such as a table, a stage plate or the like for installing a vibration-protected apparatus such as a semiconductor manufacturing apparatus or an electronic microscope on the upper surface thereof, thereby supporting the vibration isolating table 10 from the installation floor without contact. Assuming herein that two horizontal and orthogonal directions are designated an X-direction and a Y-direction, respectively, and a vertical direction is designated a Z-direction, the respective magnetic levitation devices 31 - 34 comprise three pairs of electromagnetic actuators for applying a magnetic force to a magnetic material such as a permanent magnet fixed on the vibration isolating table 10 for supporting in the three directions X, Y, Z.

Displacement sensors 41, 42, 43, 44 are attached at respective positions at which the magnetic levitation devices 31 - 34 support the vibration isolating table 10 without contact for detecting a displacement of the vibration isolating table 10 with respect to the installation floor. Each of the displacement sensors 41 - 44 detects a displacement of the vibration isolating table 10 at the position at which it is attached, and supplies the controller 5 with a displacement signal indicative of an X-component, a Y-component and a Z-component of the detected displacement. Further, for detecting vibrations of the installation floor, an appropriate number (three in Fig. 4) of acceleration sensors 61, 62, 63 are attached at appropriate positions on the installation floor. Out of these acceleration sensors 61 - 63, the acceleration sensor 61 outputs an acceleration signal indicative of an X-component, a Y-component and a Z-component of an acceleration detected at the position at which it is attached; the acceleration sensor 62 outputs an acceleration signal indicative of an X-component and a Y-component of an acceleration detected at the position at which it is attached; and the acceleration sensor 63 outputs an acceleration signal indicative of a Z-component of an acceleration detected at the position at which it is attached. These acceleration signals are supplied to the controller 5.

The controller 5 changes the magnitudes of currents for driving the respective electromagnetic actuators of the magnetic levitation devices 31 - 34 based on the signals supplied from the displacement sensors 31 - 34 and acceleration sensors 61 - 63, thereby preventing the vibration isolating table 10 from being vibrated by any cause.

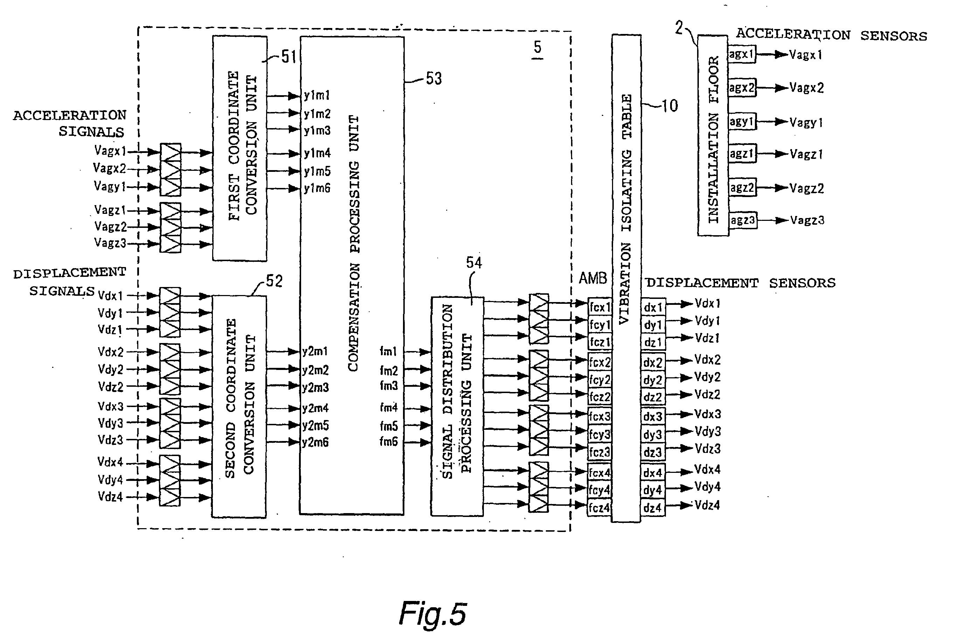

Fig. 5 is a diagram for explaining a general configuration of the controller 5 and how the controller 5 controls the magnetic levitation devices 31 - 34 in response to the signal outputted from the displacement sensors 31 - 34 and acceleration sensors 61 - 63. In Fig. 5, an acceleration signal Vagx1 indicative of an X-component of a detected acceleration, an acceleration signal Vagy1 indicative of a Y-component, and an acceleration signal Vagz1 indicative of a Z-component are output from the acceleration sensor 61 attached on the installation floor 2. Similarly, the acceleration sensor 62 outputs an acceleration signal Vagx2 indicative of an X-component of a detected acceleration, and an acceleration signal Vagz2 indicative of a Z-component of the detected acceleration, while the acceleration sensor 63 outputs an acceleration signal Vagz3 indicative of a Z-component of a detected acceleration. These acceleration signals Vagx1 - Vagz3 are amplified by sensor amplifiers before they are applied to a first coordinate conversion unit 51 of the controller 5.

The displacement sensor 31 outputs displacement signals Vdx1, Vdy1, Vdz1 indicative of an X-component, a Y-component and a Z-component of a displacement detected at its position; the displacement sensor 32 outputs displacement signals Vdx2, Vdy2, Vdz2 indicative of an X-component, a Y-component and a Z-component of a displacement detected at its position; the displacement sensor 33 outputs displacement signals Vdx3, Vdy3, Vdz3 indicative of an X-component, a Y-component and a Z-component of a displacement detected at its position; and the displacement sensor 34 outputs displacement signals Vdx4, Vdy4, Vdz4 indicative of an X-component, a Y-component and a Z-component of a displacement detected at its position. These displacement signals are amplified by sensor amplifiers before they are applied to a second coordinate conversion unit 52 of the controller 5.

The first coordinate conversion unit 51 converts the acceleration signals Vagx1 - Vagz3 received from the acceleration sensors 61 - 63 from a physical coordinate system to a mode coordinate system to generate a group of mode acceleration signals comprised of signals ylm1, ylm2, ylm3 indicative of the accelerations of the installation floor in the X-, Y- and Z-directions, respectively, and signals ylm4, ylm5, ylm6 indicative of the accelerations in rotating directions about the X-, Y- and Z-directions. The group of mode acceleration signals are applied to a compensation processing unit 53. The second coordinate conversion unit 52 converts the displacement signals Vdx1 - Vdz4 received from the displacement sensors 31 - 34 from the physical coordinate system to the mode coordinate system to generate a group of mode displacement signals comprised of signals y2m1, y2m2, y2m3 indicative of displacements of the installation floor in the X-, Y- and Z-directions, respectively, and signals y2m4, y2m5, y2m6 indicative of displacements in the rotating directions about the X-, Y- and Z-directions. The group of mode displacement signals are applied to the compensation processing unit 53.

In this way, the first coordinate conversion unit 51 and second coordinate conversion unit 52 convert an amounts represented in the physical coordinate system to an amount represented in the mode coordinate system for controlling the magnetic levitation devices. Such a conversion is performed by a mode matrix for converting an actual physical coordinate system to the mode coordinate system in which respective vibration modes are orthogonal to one another and are not coupled to the other modes.

Upon receipt of the group of mode acceleration signals and the group of mode displacement signals, the compensation processing unit 53 supplies a signal distribution processing unit 54 with a group of compensation signals comprised of six signals fm1, fm2, fm3, fm4, fm5 and fm6 corresponding to the signal u in Fig. 3. Thus, the controller 5 is a system having six degrees of freedom for controlling a rigid body mode, so that the electromagnetic actuators associated with the magnetic levitation devices 31 - 34 are independently controlled such that they do not interfere with one another in each mode in six degrees of freedom, thereby suppressing vibrations of the vibration isolating table 10.

The signal distribution processing unit 54 uses the group of compensation signals comprised of fm1 - fm6 to determine currents which should be applied to the respective electromagnetic actuators of the magnetic levitation devices 31 - 34, and amplifies these currents before they are applied to the corresponding electromagnetic actuators. In this way, it is possible to suppress vibrations of the vibration isolating table 10 itself as well as to prevent vibrations from propagating from the installation floor to the vibration isolating table 10.

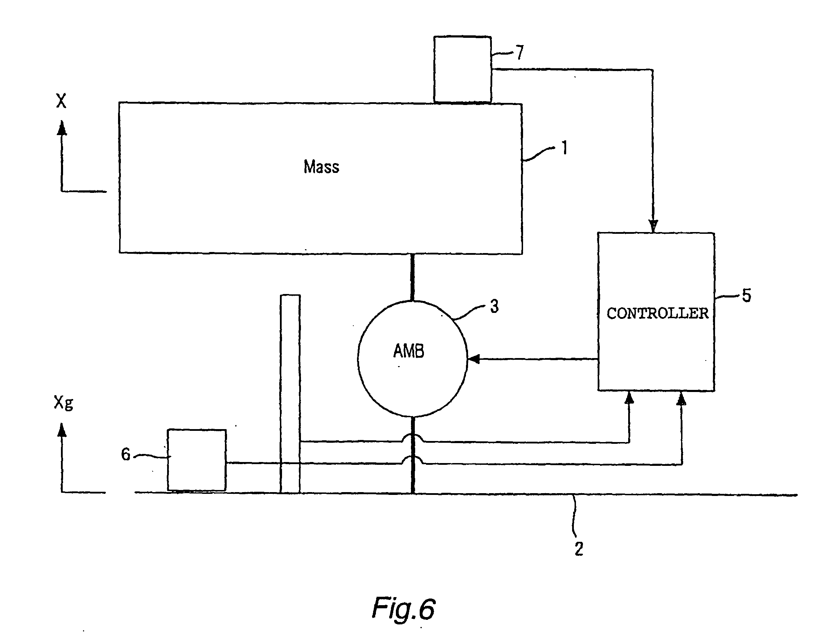

Fig. 6 is a conceptual diagram illustrating a second embodiment of a vibration isolating apparatus according to the present invention when it is represented as a system having one degree of freedom. In comparison with the first embodiment illustrated in Fig. 2, the second embodiment differs in that an additional acceleration sensor 7 is attached to the mass 1. The acceleration sensor 7 operates to detect an absolute acceleration of the mass 1 and supply this to the controller 5 as a reference signal. In this way, the controller 5 processes the displacement signals supplied thereto to generate a first control signal which is fed back to the magnetic levitation device 3 for adjusting a supporting force of the magnetic levitation device 3 to maintain the mass 1 at a predetermined position, as is the case with the first embodiment. Simultaneously, the controller 5 uses the acceleration signal from the acceleration sensor 6 as an error signal and the acceleration signal from the acceleration sensor 7 as a reference signal, and feeds a second control signal forward to the magnetic levitation device 3 to prevent vibrations of the installation floor 2 from propagating to the mass 1. Thus, the mass 1 is isolated from the vibrations of the installation floor 2.

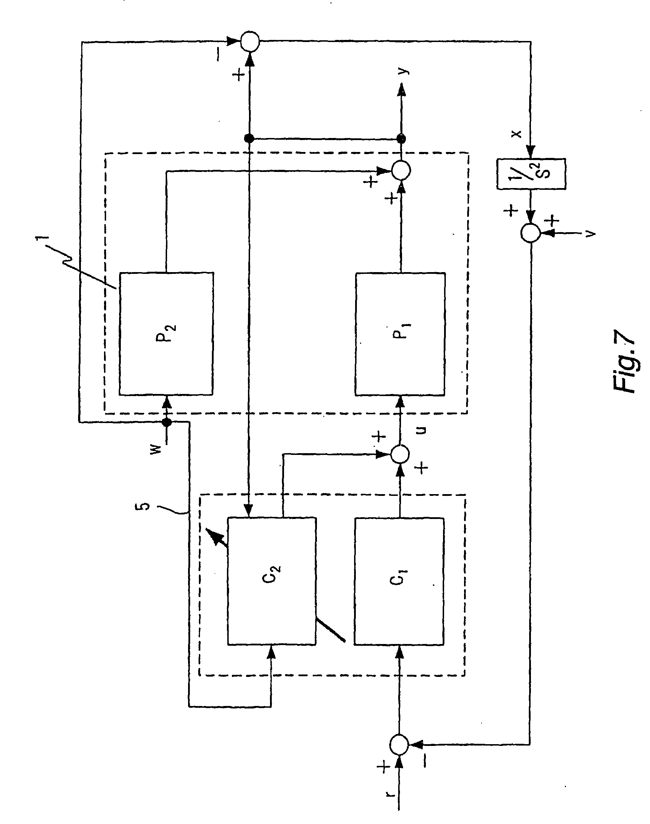

The apparatus in Fig. 6 may be re-drawn as represented by a block diagram of Fig. 7 in regard to the control system. Similar to the first embodiment, the second embodiment is also a system having two degrees of freedom. In addition, an absolute acceleration signal y is input to the controller 5 as a reference signal. The controller 5 uses this reference signal to update coefficients of the second controller $C_2$ in accordance with an adaptive algorithm, and feeds the result forward to the magnetic levitation device 3 as a control signal.

Likewise, in the control system illustrated in Fig. 7, the transfer function y/w can be changed by $C_2$ even after the transfer function y/v is determined, in a manner similar to the foregoing description made on Fig. 3 using Equations (1) - (8). $C_2$ does not affect the transfer functions y/v, y/r, so that the characteristics of the transfer function y/w can be independently adjusted by $C_2$, and y/r is determined by y/v.

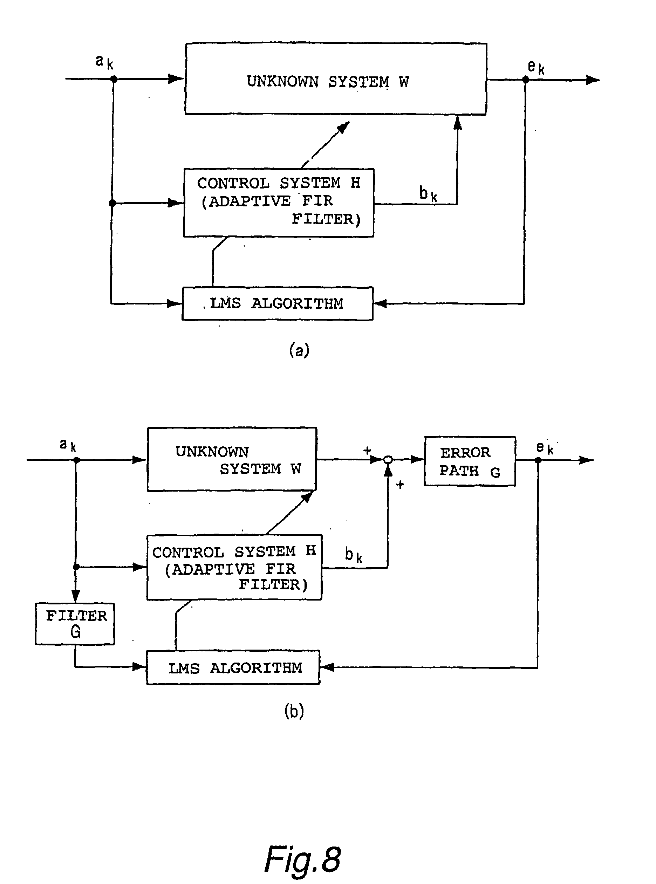

Here, the adaptive algorithm will be described. Used as an algorithm for controlling vibrations is a filtered-X LMS algorithm which is a practical approach improved from an LMS algorithm. Fig. 8(a) illustrates a block diagram of the basic LMS algorithm, where an adaptive control is conducted using an input signal $a_k$ (positive, where k represents time) to an unknown system W and an error signal $e_k$ to sequentially update a filter coefficient $h_k$ of a control system H, which has an adaptive FIR filter, in accordance with an update equation to reduce a difference $e_k$ between the input signal $a_k$ and an output $b_k$ of the control system H to zero. The update equation is given in a simple form using any step-size parameter s:

$$h_{k+1} = h_k - 2se_k a_k \tag{9}$$

Therefore, this is an algorithm quite suitable for an active vibration control (AVC) which requires a lot to calculations in real time.

The step-size parameter s in the equation is a constant indicative of a step by which the filter coefficient is updated at one time. The larger step-size parameter results in the faster convergence, but the control system tends to be instable. An optimal value for s, which depends on an input signal, the magnitude of the error signal and a filter length of H, cannot be theoretically found even at present, so that a value appropriate to each system is determined on an empirical basis.

Fig. 8(b) is a block diagram illustrating an exemplary adaptive control in accordance with the Filtered-X LMS algorithm, wherein a path error G is added, as compared with Fig. 8(a). For modeling an actual system, the error path G must be taken into consideration in order to express vibration characteristics from a control force to an acceleration sensor, as well as the control force, and the characteristic of the acceleration sensor itself. However, when the LMS algorithm is applied to a system including the error path G, the overall series connection of the error path G and unknown system W is regarded as an unknown system. Consequently, the input signal ak is supplied to the LMS algorithm after it is passed through a filter which has the same characteristics as the error path G. Therefore, in the filter coefficient update equation for the control system H, a filtered signal is used instead of ak in Equation (9).

In the adaptive control illustrated in Figs. 8(a) and 8(b), the output from the acceleration sensor 6 (i.e., vibrations w of the installation floor) corresponds to the input signal $a_k$, while the output from the acceleration sensor 7 (i.e., the absolute acceleration y indicated by the mass 1 through vibrations) corresponds to the error signal $e_k$.

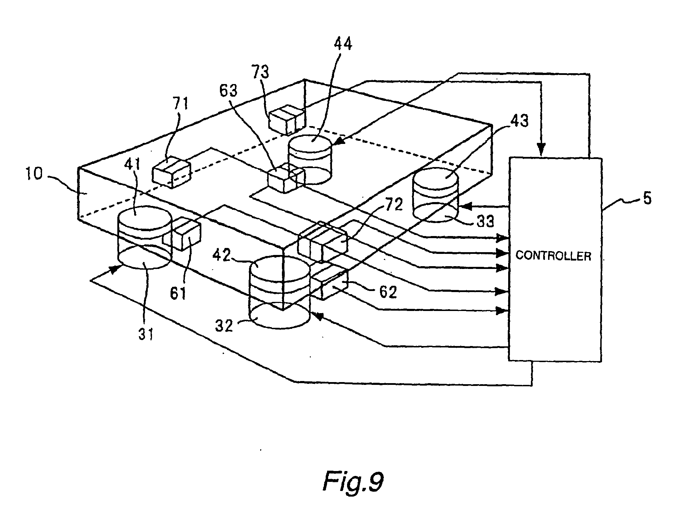

Fig. 9 illustrates a specific configuration of the second embodiment of the vibration isolating apparatus according to the present invention. In the second embodiment, three acceleration sensors 71 - 73 are attached on the table 10 in addition to the four magnetic levitation devices 31 - 34 for supporting the table 10 without contact, the displacement sensors 41 - 44 for detecting relative displacements of the table 10, and the acceleration sensors 61 - 63 attached on the installation floor. Displacement signals from the displacement sensors 41 - 44 and acceleration signals from the acceleration sensors 61 - 63 and acceleration sensors 71 - 73 are applied to the controller 5. Upon receipt of these signals, the controller 5 controls magnetic supporting forces of the magnetic levitation devices 31 - 34. Stated another way, the coefficient of the controller 5 is updated in accordance with the adaptive algorithm using the acceleration signals from the acceleration sensors 61 - 63, indicative of vibrations of the installation floor, as reference signals and using the acceleration signals from the acceleration sensors 71 - 73, indicative of vibrations of the table 10, as error signals, to control the magnetic levitation devices 31 - 34 in a feed forward manner.

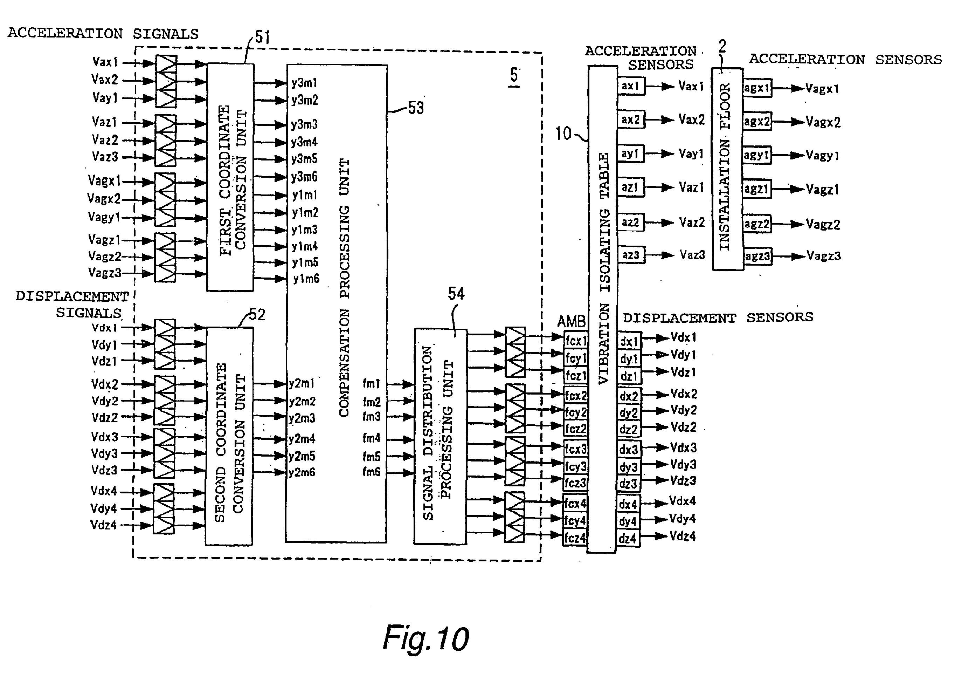

As illustrated in Fig. 10, the displacement signals Vdx1 - Vdz4 from the displacement sensors 41 - 44, the acceleration signals Vagx1 - Vagz3 from the acceleration sensors 61 - 63, and acceleration signals Vsx1 - Vaz3 from 71 - 73 in the vibration isolating apparatus illustrated in Fig. 9 are processed by the controller 5 in the following manner. Since the description in Fig. 5 applies to the displacement signals Vdx1 - Vdz4 from the displacement sensors 41 - 44 and the acceleration signals Vagx1 - Vagz3 from the acceleration sensors 61 - 63, these are omitted in the following description.

Out of the acceleration sensors 71 - 73 attached on the table 10, the acceleration sensor 71 outputs an acceleration signal Vax1 indicative of an X-component of a detected acceleration, an acceleration signal Vay1 indicative of a Y-component, and an acceleration signal Vaz1 indicative of a Z-component. Similarly, the acceleration sensor 72 outputs an acceleration signal Vax2 indicative of an X-component of a detected acceleration and an acceleration signal Vaz2 indicative of a Z-component of the detected acceleration, while the acceleration sensor 73 outputs an acceleration signal Vaz3 indicative of a Z-component of a detected acceleration. These acceleration signals Vax1 - Vaz3 are am-

**EP 1 304 499 A1**

plified by sensor amplifiers before they are applied to the first coordinate conversion unit 51 of the controller 5.

The first coordinate conversion unit 51 converts the acceleration signals Vagx1 - Vagz3 received from the acceleration sensors 61 - 63 on the installation floor from the physical coordinate system to the mode coordinate system to generate a group of first mode acceleration signals comprised of signals y1m1, ylm2, ylm3 indicative of accelerations of the installation floor in the X-, Y- and Z-directions, respectively, and a group of signals ylm4, ylm5, ylm6 indicative of accelerations in the rotating directions about the X-, Y- and Z-directions, respectively. The group of first mode acceleration signals are applied to the compensation processing unit 53.

The first coordinate conversion unit 51 also converts the acceleration signals Vax1 - Vaz3 received from the acceleration sensors 71 - 73 on the table 10 from the physical coordinate system to the mode coordinate system to generate a group of second mode acceleration signals comprised of signals y3m1, y3m2, y3m3 indicative of accelerations of the table 10 in the X-, Y-, Z-directions, respectively, and signals y3m4, y3m5, y3m6 indicative of accelerations in the rotating directions about the X-, Y-, Z-directions, respectively. The group of second mode acceleration signals are applied to the compensation processing unit 53.

The second coordinate conversion unit 52 converts the coordinates of the displacement signals Vdx1 - Vdz4 received from displacement sensors 31 - 34 to generate a group of mode conversion signals comprised of signals y2m1, y2m2, y2m3 indicative of displacements of the installation floor in the X-, Y- and Z-directions, respectively, and signals y2m4, y2m5, y2m6 indicative of displacements in the rotating directions about the X-, Y- and Z-directions, respectively. The group of mode displacement signals are applied to the compensation processing unit 53.

Upon receipt of the group of first mode acceleration signals, the group of second acceleration signals and the group of mode displacement signals, the compensation processing unit 53 operates to determine the magnitudes of currents which should be applied to the electromagnetic actuators of the magnetic levitation devices 31 - 34 for suppressing vibrations on the vibration isolating table 10. Further, the compensation processing unit 53 supplies the signal distribution processing unit 54 with a group of compensation signals comprised of six signals fm1, fm2, fm3, fm4, fm5 and fm6. The group of compensation signals correspond to the signal u in Fig. 7. The signal distribution processing unit 54 determines currents to be applied to the respective electromagnetic actuators of the magnetic levitation devices 31 - 34 using the group of compensation signals comprised of fm1 - fm6, and amplifies these currents before they are applied to the corresponding electromagnetic actuators. In this way, it is possible to suppress vibrations of the vibration isolating table 10 itself as well as to prevent vibrations from propagating from the installation floor to the vibration isolating table 10.

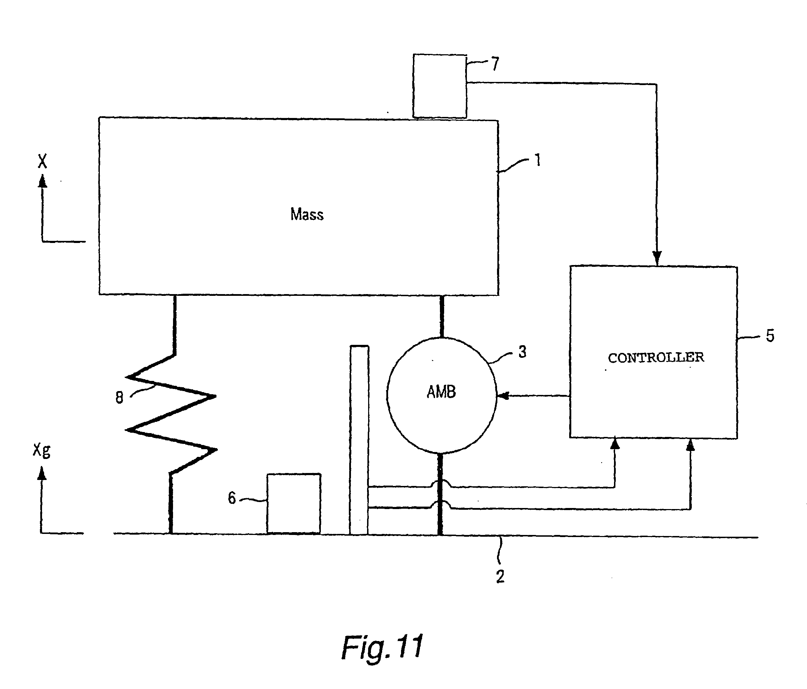

Fig. 11 illustrates the configuration of a third embodiment of a vibration isolating apparatus according to the present invention. In the first and second embodiments so far described, the table 10 is supported only by the magnetic levitation devices 31 - 34, whereas in the third embodiment, the table 10 is supported by a resilient supporting member 8 in addition to the magnetic levitation device 3, as illustrated in Fig. 1. The resilient supporting member 8 is preferably, for example, a spring element such as a coil spring, an air spring, a rubber material, a magnetic spring using a magnet, or the like. By thus supporting the table 10 additionally by the resilient supporting member 8, the burden on the magnetic levitation device 3 can be mitigated to more stably support the table 10.

INDUSTRIAL AVAILABILITY

As will be apparent from the embodiments of the vibration isolating apparatus according to the present invention described above, the present invention produces remarkable advantageous effects of extremely stably supporting the vibration isolating table based on the outputs of the displacement sensors as well as preventing disturbance such as vibrations of a foundation from propagating to the vibration isolating table without fail.

In addition, since the acceleration sensors are additionally attached on the vibration isolating table to permit the controller to also process acceleration signals indicative of vibrations of the vibration isolating table in addition to the acceleration signals indicative of the basic vibrations, the controller can more accurately control the magnetic levitation device, thereby accomplishing high performance vibration isolation.

**Claims**

1. A vibration isolating apparatus **characterized by** comprising:

   a vibration isolating table for installing a vibration-protected apparatus thereon;
   an electromagnetic actuator for supporting said vibration isolating table without contact and applying a control force thereto;
   displacement detecting means for detecting an amount of a relative displacement of said vibration isolating table with respect to a foundation which defines a reference position to output a displacement signal;

8

first vibration detecting means for outputting a first acceleration signal upon detection of vibrations of said foundation;

a first control loop for applying a predetermined compensation to said displacement signal and feeding the compensated displacement signal back to said electromagnetic actuator to determine a relative position of said vibration isolating table with respect to said reference position; and

a second control loop for compensating said first acceleration signal and feeding the compensated first acceleration signal forward to said electromagnetic actuator to prevent vibrations from propagating from said foundation to said vibration isolating table.

2. A vibration isolating apparatus according to claim 1,
   **characterized by** further comprising:

   second vibration detecting means for outputting a second acceleration signal upon detection of the vibrations of said vibration isolating table,

   wherein said second control loop prevents the vibrations of said foundation from propagating to said vibration isolating table using said first acceleration signal as an error signal and said second acceleration signal as a reference signal.

3. A vibration isolating apparatus according to claim 1 or 2, **characterized in that**:

   said electromagnetic actuator exerts a magnetic force to a magnetic material fixed to said vibration isolating table to apply a control force for supporting said vibration isolating table without contact.

4. A vibration isolating apparatus according to any of claims 1 - 3, **characterized in that**:

   said first control loop includes a PID compensator and a phase advance/delay compensator; and
   said second control loop includes an adaptive filter for updating a filter coefficient based on an adaptive algorithm to form a feed-forward signal.

5. A vibration isolating apparatus according to any of claims 1 - 4, **characterized by** further comprising:

   a resilient supporting member for supporting said vibration isolating table.

6. A vibration isolating apparatus according to any of claims 1 - 5, **characterized in that**:

   said vibration isolating table is a table or a stage plate for supporting said vibration-protected object.

*Fig.1*

EP 1 304 499 A1

Fig.2

EP 1 304 499 A1

Fig.3

Fig.4

Fig.5

EP 1 304 499 A1

*Fig.6*

EP 1 304 499 A1

*Fig.7*

(a)

(b)

## Fig.8

*Fig.9*

ACCELERATION SIGNALS

Vax1
Vax2
Vay1

Vaz1
Vaz2
Vaz3

Vagx1
Vagx2
Vagy1

Vagz1
Vagz2
Vagz3

FIRST COORDINATE CONVERSION UNIT — 51

y3m1
y3m2
y3m3
y3m4
y3m5
y3m6
y1m1
y1m2
y1m3
y1m4
y1m5
y1m6

COMPENSATION PROCESSING UNIT — 53

5

DISPLACEMENT SIGNALS

Vdx1
Vdy1
Vdz1

Vdx2
Vdy2
Vdz2

Vdx3
Vdy3
Vdz3

Vdx4
Vdy4
Vdz4

SECOND COORDINATE CONVERSION UNIT — 52

y2m1
y2m2
y2m3
y2m4
y2m5
y2m6

fm1
fm2
fm3
fm4
fm5
fm6

SIGNAL DISTRIBUTION PROCESSING UNIT — 54

AMB

fcx1
fcy1
fcz1

fcx2
fcy2
fcz2

fcx3
fcy3
fcz3

fcx4
fcy4
fcz4

VIBRATION ISOLATING TABLE — 10

ACCELERATION SENSORS — 2

ax1 → Vax1
ax2 → Vax2
ay1 → Vay1
az1 → Vaz1
az2 → Vaz2
az3 → Vaz3

INSTALLATION FLOOR

ACCELERATION SENSORS

agx1 → Vagx1
agx2 → Vagx2
agy1 → Vagy1
agz1 → Vagz1
agz2 → Vagz2
agz3 → Vagz3

DISPLACEMENT SENSORS

dx1 → Vdx1
dy1 → Vdy1
dz1 → Vdz1
dx2 → Vdx2
dy2 → Vdy2
dz2 → Vdz2
dx3 → Vdx3
dy3 → Vdy3
dz3 → Vdz3
dx4 → Vdx4
dy4 → Vdy4
dz4 → Vdz4

*Fig.10*

EP 1 304 499 A1

*Fig.11*

EP 1 304 499 A1

<div align="center">

**INTERNATIONAL SEARCH REPORT**

</div>

| | International application No. |
|---|---|
| | PCT/JP01/06050 |

**A. CLASSIFICATION OF SUBJECT MATTER**
Int.Cl$^7$  F16F 15/03, G05D 19/02

According to International Patent Classification (IPC) or to both national classification and IPC

**B. FIELDS SEARCHED**

Minimum documentation searched (classification system followed by classification symbols)
Int.Cl$^7$  F16F 15/02~15/03, G05D 19/02

Documentation searched other than minimum documentation to the extent that such documents are included in the fields searched
Jitsuyo Shinan Koho        1926-1996    Toroku Jitsuyo Shinan Koho  1994-2001
Kokai Jitsuyo Shinan Koho  1971-2001    Jitsuyo Shinan Toroku Koho  1996-2001

Electronic data base consulted during the international search (name of data base and, where practicable, search terms used)
esp@cenet

**C. DOCUMENTS CONSIDERED TO BE RELEVANT**

| Category* | Citation of document, with indication, where appropriate, of the relevant passages | Relevant to claim No. |
|---|---|---|
| X | JP 8-326834 A (Canon Inc.),<br>10 December, 1996 (10.12.96),<br>Full text<br>(Family: none) | 1,2,3,5,6 |
| Y | | 4 |
| Y | EP 789160 A2 (Ebara Corporation, et al.),<br>13 August, 1997 (13.08.97),<br>Full text<br>& JP 9-112628 A    & US 5793598 A1 | 1~7 |
| Y | JP 7-332431 A (Bridgestone Corporation),<br>22 December, 1995 (22.12.95),<br>Full text<br>(Family: none) | 1~7 |
| X | JP 5-99271 A (Tokkyo Kiki K.K.),<br>20 April, 1993 (20.04.93),<br>Claims; Par. No. [0010]    (Family: none) | 1,3,6 |
| A | | 4 |

☒ Further documents are listed in the continuation of Box C.        ☐ See patent family annex.

| | |
|---|---|
| *      Special categories of cited documents:<br>"A"   document defining the general state of the art which is not considered to be of particular relevance<br>"E"   earlier document but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |
| Date of the actual completion of the international search<br>19 September, 2001 (19.09.01) | Date of mailing of the international search report<br>02 October, 2001 (02.10.01) |
| Name and mailing address of the ISA/<br>Japanese Patent Office | Authorized officer |
| Facsimile No. | Telephone No. |

Form PCT/ISA/210 (second sheet) (July 1992)

**INTERNATIONAL SEARCH REPORT**

International application No.

PCT/JP01/06050

C (Continuation). DOCUMENTS CONSIDERED TO BE RELEVANT

| Category* | Citation of document, with indication, where appropriate, of the relevant passages | Relevant to claim No. |
|---|---|---|
| A | JP 9-250592 A (Canon Inc.),<br>22 September, 1997 (22.09.97),<br>Full text<br>(Family: none) | 1~7 |
| A | JP 10-132018 A (Mitsubishi Electric Corporation),<br>22 May, 1998 (22.05.98),<br>Full text<br>(Family: none) | 1~7 |
| A | JP 5-263868 A (Tokkyo Kiki K.K.),<br>12 October, 1993 (12.10.93),<br>Claims<br>(Family: none) | 1~7 |
| A | JP 6-294445 A (Ebara Corporation),<br>21 October, 1994 (21.10.94),<br>Claims<br>(Family: none) | 1~7 |

Form PCT/ISA/210 (continuation of second sheet) (July 1992)